# FASCICULE DE BREVET EUROPEEN

(11) **EP 0 618 654 B1**
(45) Date de publication et mention de la délivrance du brevet: **21.08.1996**
(21) Numéro de dépôt: 94400646.9
(22) Date de dépôt: 25.03.1994
(51) Int. Cl.: H01S 3/25, G02F 1/025

(54) **Modulateur optique d'amplitude utilisant une structure de type laser DFB biélectrode**
Lichtintensitätsmodulator unter Verwendung eines DFB Lasers mit zwei Elektroden
Optical intensity modulator using a two-electrode DFB laser

(30) Priorité: 29.03.1993 FR 9303591
(43) Date de publication de la demande: 05.10.1994
(73) Titulaire: FRANCE TELECOM, F-75015 Paris (FR)
(72) Inventeur: Gay, Emmanuel, F-22700 Perros Guirec (FR); Chawki, Mouhamad, F-22300 Lannion (FR); Le Ligne, Marc, F-22560 Pleumeur-Bodou (FR)
(74) Mandataire: Signore, Robert

(56) Documents cités:
- JOURNAL OF LIGHTWAVE TECHNOLOGY., vol.10, no.10, Octobre 1992, NEW YORK US pages 1388 - 1396 M. J. CHAWKI ET AL 'Two-electrode DFB laser filter used as a wide tunable narrow band FM receiver: tuning analysis, characteristics and experimental FSK.WDM system'
- TRANSACTIONS OF THE INSTITUTE OF ELECTRONICS, INFORMATION AND COMMUNICATION ENGINEERS OF JAPAN, vol.E71, no.10, Octobre 1988, TOKYO JP pages 972 - 974 M. FUJIWARA ET AL '1.55 mum laser diode optical modulator'
- IBM TECHNICAL DISCLOSURE BULLETIN., vol.36, no.2, Février 1993, NEW YORK US pages 43 - 45 'Self-tuning optical external modulator'
- PROCEEDINGS OF THE ECOC CONFERENCE 1992, PAPER WEB8.4 pages 385 - 388 T. N. NIELSEN ET AL 'Chirp free 2.5 Gbit/s amplitude modulation/gating in two electrode semiconductor optical amplifiers'

## Description

### Domaine technique

La présente invention a pour objet un modulateur optique d'amplitude utilisant une structure de type laser DFB biélectrode.

Elle trouve une application en télécommunications optiques.

### Etat de la technique

La modulation d'amplitude d'un faisceau optique s'obtient classiquement au moyen d'un cristal biréfringent, (en niobate de lithium par exemple), auquel on applique une tension modulée.

Une telle technique présente l'inconvénient d'introduire des pertes optiques importantes et de nécessiter l'utilisation de hautes tensions.

Une autre technique consiste à utiliser une source laser modulée en fréquence puis à convertir cette modulation de fréquence (généralement désignée par FSK pour "Frequency Shift Keying") en modulation d'amplitude (désignée par ASK pour "Amplitude Shift Keying"). Cette technique est décrite, par exemple, dans l'article de D. MARCUSE, intitulé "Computer Simulation of FSK Laser Spectra and of FSK-to-ASK conversion" publié dans "Journal Lightwave Technol.", vol. 8, n° 7, juillet 1990, pp. 1110-1122.

Dans cette technique, il subsiste cependant une légère modulation de fréquence. Elle se traduit par une déformation du signal optique au cours de sa propagation dans la fibre optique de liaison. On sait, en effet, que la dispersion chromatique d'une fibre optique classique (type G 652), qui est de l'ordre de 15 à 17 ps/km/nm, déforme le train d'onde optique et limite le débit des informations. Cette technique n'est donc pas sans inconvénient.

Plus récemment, sont apparus d'autres dispositifs qui sont des amplificateurs à semiconducteur. Ils sont décrits notamment dans l'article de B. FERNIER, P. GARABEDIANE, E. DEROUIN et F. LEBLOND, intitulé "Chirp-Free 2.5 Gbit/s Amplitude Modulation/Gating in Two-Electrode Semiconductor Optical Amplifiers", publié dans "Proceedings of ECOC'92", 1992. Mais ces dispositifs sont limités en débit.

La présente invention a justement pour but de remédier à ces inconvénients. A cette fin, elle préconise d'utiliser un dispositif en soi connu, qui est une structure de type laser à rétroaction distribuée (ou DFB en abrégé pour "Distributed FeedBack") biélectrode.

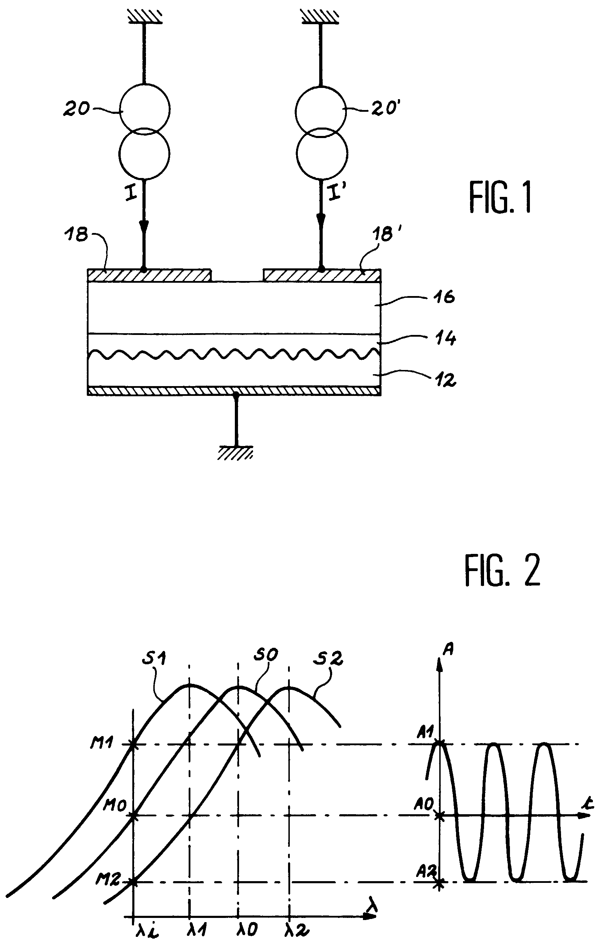

La figure 1 annexée rappelle brièvement en quoi consiste cette structure. Elle comprend une couche inférieure de confinement 12, une couche active 14, une couche supérieure de confinement 16, deux électrodes 18 et 18' et deux sources de courant 20 et 20'.

Ces structures DFB multiélectrodes sont déjà connues dans le domaine des télécommunications optiques où elles jouent le rôle de filtre optique accordable quand elles sont polarisées en dessous du seuil. Ce genre de filtre peut être utilisé comme photodétecteur ou comme discriminateur pour faisceaux modulés en fréquence. Une telle structure et de telles applications sont décrites dans l'article de M.J. CHAWKI, R. AUFFRET, E. LE COQUIL, P. POTTIER, L. BERTHOU, H. PACIULLO et J. LE BIHAN, intitulé "Two-Electrode DFB Laser Filter Used as a Wide Tunable Narrow-Band FM Receiver : Tuning Analysis, Characteristics and Experimental FSK-WDM System", publié dans "Lightwave Technol.", vol. 10, n 10, octobre 1992, pp. 1388-1397 ainsi que dans l'article de M.J. CHAWKI, R. AUFFRET, L. BERTHOU intitulé "1.5 Bbit/s FSK Transmission System Using Two-Electrode DFB Laser as Tunable FSK Discriminator/Photodetector", publié dans "Electron. Lett.", juillet 1990, vol. 26, n° 15, pp. 1146-1147.

### Exposé de l'invention

La présente invention propose une autre fonction pour ce dispositif, qui est la modulation d'amplitude. A cette fin, l'un au moins des deux courants d'alimentation est modulé en intensité juste en dessous du seuil assurant le fonctionnement du filtre, ce qui a pour effet de déplacer en longueur d'onde le pic d'émission spontanée. Si la structure est conçue pour que la longueur d'onde du faisceau traversant la couche active tombe sur l'un des flancs du pic (flanc de montée ou flanc de descente), alors, du fait du déplacement du pic, l'amplitude du faisceau émergeant va se trouver modulée.

La modulation d'amplitude obtenue dans ces conditions n'agit en rien sur la fréquence du faisceau incident. Il n'y a donc pas de changement de fréquence ("chirp") dans le faisceau obtenu.

Par ailleurs, le passage à travers la couche active de la struture ne s'accompagne pas d'une atténuation, comme c'est le cas pour le niobate de lithium. Au contraire, le faisceau peut se trouver amplifié, comme cela a été décrit par K. MAGARI, H. KAWAGUCHI, K. OE et M. FUKUDA, dans un article intitulé "Optical Narrow-Band Filter Using Optical Amplification with Distributed FeedBack", publié dans "IEEE J. Quantum Electron.", vol. 24, n° 11, novembre 1988, pp. 2178-2190.

De façon précise, la présente invention a donc pour objet un modulateur optique d'amplitude comprenant :
- une structure semiconductrice du type laser à rétroaction distribuée,
- deux électrodes situées sur cette structure,
- des moyens pour engendrer deux courants et les appliquer aux deux électrodes pour alimenter la structure en dessous du seuil d'oscillation laser, la structure présentant alors un pic d'émission spontanée avec un flanc de montée et un flanc de descente,
- des moyens pour moduler en intensité l'un au moins des deux courants,
ce modulateur étant ainsi apte à moduler en amplitude un faisceau optique le traversant et présentant une longueur d'onde tombant sur l'un des flancs du pic d'émission spontanée.

### Brève description des dessins

- la figure 1, déjà décrite, montre schématiquement une structure semiconductrice à rétroaction distributée (DFB) à deux électrodes ;
- la figure 2 illustre le principe de fonctionnement du modulateur de l'invention ;
- la figure 3 montre le déplacement du spectre d'émission spontanée théorique d'un laser DFB biélectrode pour un courant fixe et un courant variable ;
- la figure 4 illustre une plage de déplacement maximal théorique pour un laser DFB en fonction des courants injectés ;
- la figure 5 illustre un équipement permettant de mesurer la modulation d'amplitude ;
- la figure 6 montre un spectre d'émission spontanée réel d'un laser DFB biélectrode ;
- la figure 7 montre le spectre d'émission spontanée réel du laser DFB biélectrode soumis à une injection optique ;
- la figure 8 montre la modulation d'amplitude obtenues selon le flanc utilisé du pic d'émission spontanée ;
- la figure 9 permet de comparer le signal optique en sortie du modulateur avec et sans injection de faisceau optique ; et
- la figure 10 est une courbe de réponse du modulateur en fonction de la fréquence de la modulation avec et sans injection optique.

### Exposé détaillé d'un mode de réalisation

On voit, sur la figure 2, des pics d'émission spontanée S₀, S₁, S₂, caractéristiques d'une structure DFB biélectrode alimentée en dessous du seuil. La longueur d'onde figure en abscisses et l'intensité en ordonnées, le tout en unités arbitraires.

Le pic S₀ est obtenu pour un certain courant injecté dans la structure à travers les deux électrodes. Il culmine à une longueur d'onde λ₀. Si l'on modifie l'intensité de l'un des courants, le pic se déplace en longueur d'onde, vers S₁ par exemple, et vient culminer à λ₁. Si l'on modifie dans l'autre sens la même intensité, le pic se déplace vers S₂ et va culminer à λ₂.

On considère alors un faisceau optique incident dont la longueur d'onde λ_{*i*} tombe, par exemple, sur le flanc de montée du pic. Lorsque ce faisceau traverse la structure, son amplitude va se trouver modifiée lors du déplacement du pic. Lorsque le pic se déplace de S₁ à S₂ puis de S₂ à S₁, le point se déplace entre M₁ et M₂ et l'amplitude du faisceau émergeant oscille entre une amplitude élevée A₁ (correspondant au pic S₁) et une amplitude basse A₂ (correspondant au pic S₂). Mais la longueur d'onde du faisceau reste égale à λ_{*i*}.

Ainsi, une modulation de l'un des courants produira-t-elle une modulation d'amplitude du faisceau optique ayant traversé la structure.

Naturellement, ce mode de fonctionnement vaut aussi bien pour le front de montée que pour le front de descente situé au-delà du sommet du pic. La seule différence est un changement de phase de la modulation (de 180°). Le seul point important est donc que le point de fonctionnement reste sur l'un des flancs, autrement dit que la longueur d'onde λ_{*i*} du faisceau incident soit toujours ou un peu inférieure à la plus petite longueur d'onde λ₁ du pic ou toujours un peu supérieure à la plus grande longueur d'onde λ₂.

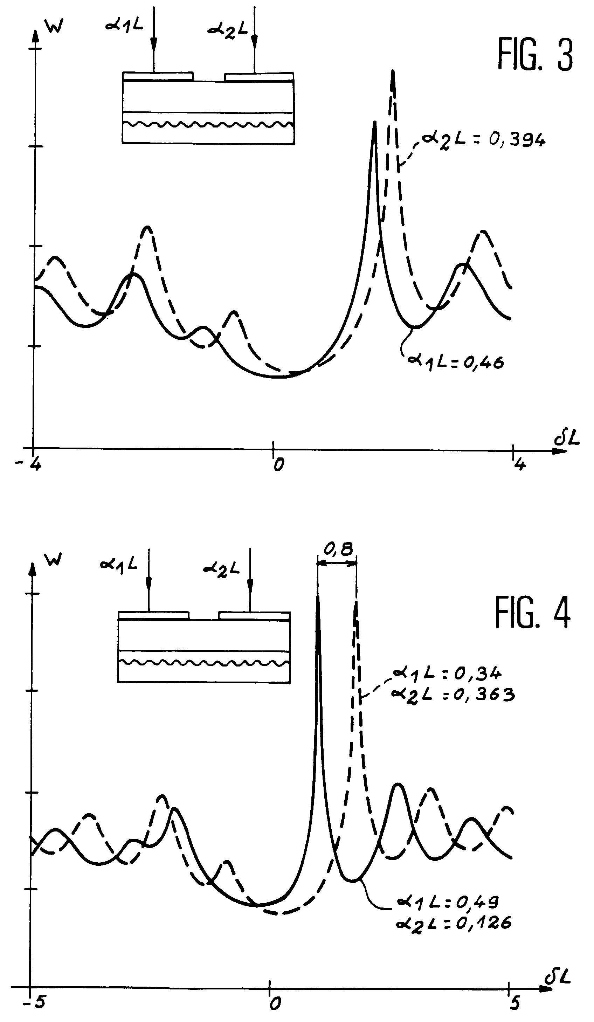

La figure 3 montre deux spectres théoriques obtenus avec une structure DFB biélectrode fonctionnant en dessous du seuil. Le calcul du spectre théorique est basé sur une méthode développée par T. MAKINO dans l'article intitulé "Transfer Matrix Analysis of Amplified Spontaneous Emission of DFB Semiconductor Laser Amplifiers", publié dans IEEE, J. Quantum Electron., vol. 24, pp. 1507-1518, août 1988.

Les deux spectres correspondent à un même courant injecté dans la première électrode 18 et un courant prenant deux valeurs différentes dans la seconde électrode 18'. Dans cette figure, en abscisses est portée la quantité ∂L et en ordonnées, la puissance optique du laser W. ∂ est la déviation de BRAGG définie par ∂=β-β₀ où *B*₀=π/Λ et Λ le pas du réseau. L est la longueur de l'électrode considérée. Les courants sont repérés par repérés par une quantité α*L* où α représente le gain de la zone active située sous l'électrode, ce gain étant directement relié au courant injecté. Sur la figure 3, les deux courbes correspondent toutes deux à α₁L=0,34 et respectivement à α₂L=0,46 pour l'une et α₂L=0,394 pour l'autre.

La figure 4 montre l'écart maximum qu'on peut obtenir avec la structure utilisée. Les deux courbes extrêmes correspondent à α₁,L=0,49 et α₂L=0,126 d'une part (pic de gauche) et α₁L=0,34 et α₂L=0,363 d'autre part (pic de droite). L'écart total entre les deux pics est Δ₁L=0,8.

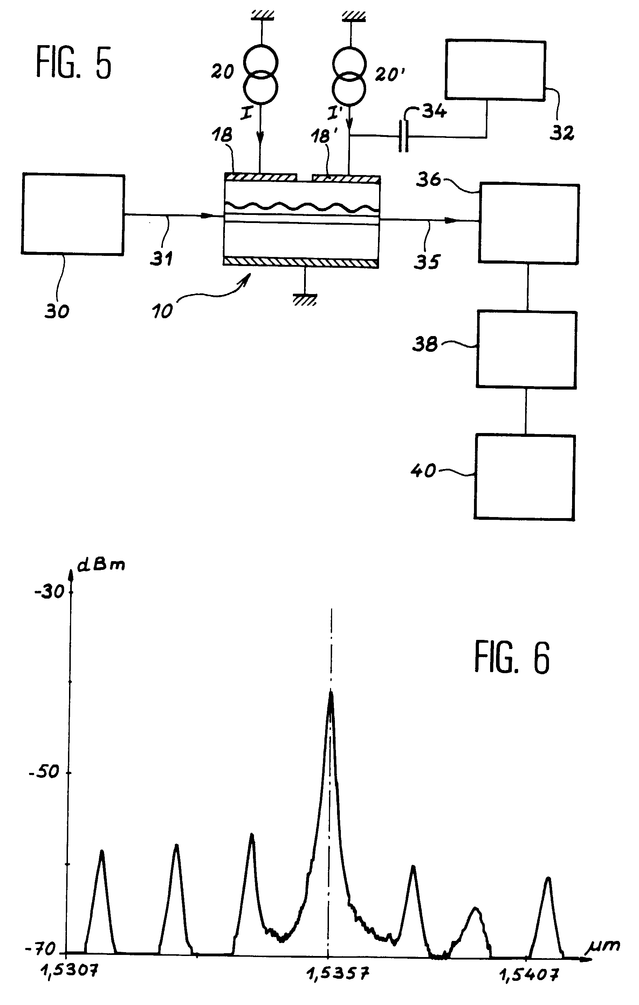

La figure 5 représente un équipement permettant de mesurer les caractéristiques de la modulation d'amplitude obtenue selon l'invention. La structure DFB biélectrode porte la référence 10. Elle reçoit d'une source laser 30 un faisceau incident 31 ayant une longueur d'onde λ_{*i*}. Les courants I et I' alimentant les deux électrodes 18, 18' sont réglés pour que la longueur d'onde λ_{*i*} tombe sur l'un des flancs du pic d'émission spontanée de la structure. Celle-ci comprend en outre un générateur de courant sinusoïdal 32, qui vient moduler le courant I' à travers un condensateur 34. Le faisceau optique 35 émergeant de la structure 10 est détecté par un détecteur 36, lequel est relié à un amplificateur 38, par exemple de 55 dB, lequel est relié finalement à un oscilloscope ou un analyseur de spectre 40.

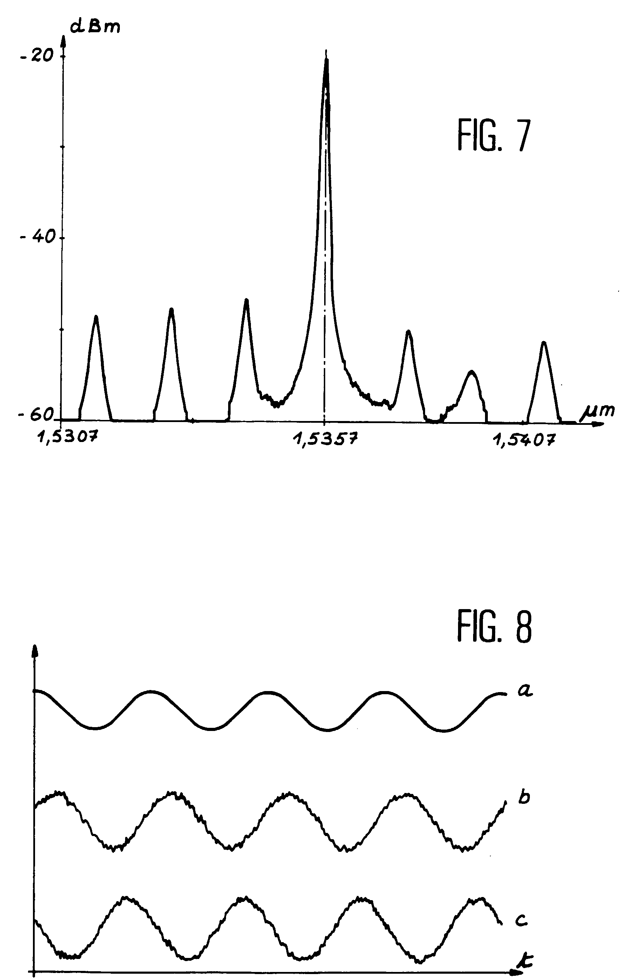

Les figures 6 et 7 montrent le spectre d'émission spontanée réel du laser DFB biélectrode sans et avec injection optique. En abscisses figure la longueur d'onde en micromètre et en ordonnées l'intensité en dBm.

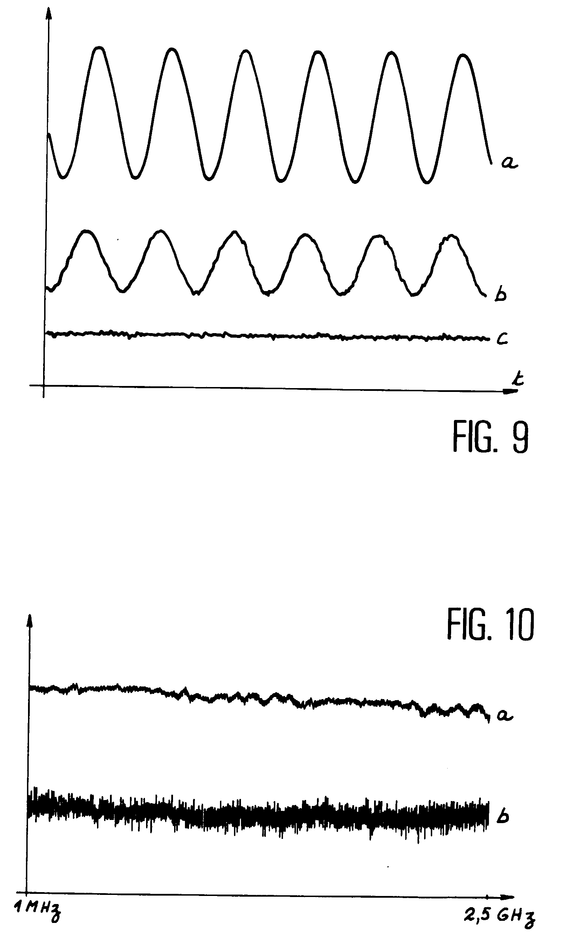

Avec l'installation de la figure 5, on peut relever des courbes telles que celles des figures 8 à 10.

La figure 8 tout d'abord, montre, sur la ligne (a), le courant sinusoïdal de modulation. Dans l'expérience illustrée, l'amplitude crête à crête de ce courant était de 2,52 mA. Le courant I constant valait, lui, 8,2 mA.

Les lignes (b) et (c) montrent la modulation d'amplitude obtenue sur le faisceau optique de sortie 35. Le faisceau d'entrée 31 avait une puissance de 200 µW et sa longueur d'onde λ_{*i*} était de 1535,295 nm. Pour placer cette longueur d'onde sur le front de montée du pic d'émission spontanée, un courant de 4,1 mA a été injecté sur l'électrode 18' (ligne b) et, pour la placer sur le front de descente, un courant de 4,3 mA (ligne c). A ces courants se superposent donc le courant de modulation de 2,52 mA représenté ligne (a).

On observe que les deux modulations d'amplitude sont en opposition de phase, ce qui n'est pas surprenant puisqu'elles correspondent aux deux flancs de pentes opposées du pic d'émission spontanée.

L'amplitude de modulation est, dans le cas représenté, de 14 dBm.

Pour vérifier que la modulation d'amplitude obtenue est bien due au phénomène décrit et non à une modulation qui résulterait de la lumière spontanée de la structure, des mesures comme celles de la figure 9 ont été effectuées. La ligne (a) montre toujours un courant sinusoïdal de modulation et la ligne (b) le signal optique de sortie modulé en amplitude. La puissance optique incidente était de 500 µW à 1535,295 nm. Le courant I injecté sur l'électrode 18 était de 8,2 mA et le courant I' sur l'électrode 18' de 4,3 mA. La ligne (c) montre l'intensité lumineuse spontanée sortant du modulateur lorsque le faisceau d'entrée est supprimé. Manifestement, il n'est affecté d'aucune modulation d'amplitude. Ainsi, toute la modulation observée ligne (b) correspond-t-elle au faisceau optique ayant traversé le modulateur.

La figure 10, enfin, montre la courbe de réponse du modulateur en fonction de la fréquence. Celle-ci est portée en abscisses et va de 1 MHz à 2,5 GHz. La puissance injectée dans le modulateur était encore de 500 µW et la longueur d'onde de 1535,295 nm. Les courants I et I' étaient respectivement de 7,7 mA et 4,5 mA, ce dernier courant étant modulé pour obtenir une modulation d'amplitude de 14 dBm. La ligne (a) montre la réponse en fréquence du modulateur avec faisceau optique injecté et la ligne (b) cette réponse sans faisceau optique injecté. La réponse est plate jusqu'à 2,5 GHz. Le Demandeur a observé que cette réponse restait plate jusqu'à au moins 3,6 GHz.

## Revendications

1. Modulateur optique d'amplitude comprenant :
- une structure semiconductrice (10) du type laser à rétroaction distribuée,
- deux électrodes (18, 18') situées sur cette structure,,
- des moyens (20, 20') pour engendrer deux courants (I, I') et les appliquer aux deux électrodes (18, 18') pour alimenter la structure en dessous du seuil d'oscillation laser, la structure présentant alors un pic d'émission spontanée (*S*₀,*S*₁,*S*₂) avec un flanc de montée et un flanc de descente,
- des moyens (32, 34) pour moduler en intensité l'un au moins des deux courants (I'),
ce modulateur étant ainsi apte à moduler en amplitude un faisceau optique (31) le traversant et présentant une longueur d'onde (λ_{*i*}) tombant sur l'un des flancs du pic d'émission spontanée.

## Patentansprüche

1. Lichtintensitätsmodulator, umfassend:
- eine Halbleiteranordnung des Typs Laser mit verteilter Rückkopplung,
- zwei Elektroden (18, 18'), die auf dieser Anordnung angeordnet sind,
- eine Einrichtung (20, 20'), um zwei Ströme (I, I') zu erzeugen und sie an die zwei Elektroden (18, 18') anzulegen, um die Anordnung unterhalb der Laseroszillationsschwelle zu versorgen, wobei die Anordnung eine Spitze spontaner Emission (S₀, S₁, S₂) mit einer steigenden Flanke und einer fallenden Flanke wiedergibt,
- eine Einrichtung (32, 34) zum Modulieren der Intensität von mindestens einem der beiden Ströme (I'),
wobei dieser Modulator zur Amplitudenmodulation eines optischen Strahls (31) geeignet ist, der ihn durchquert und eine Wellenlänge (λᵢ) aufweist, die auf eine der Flanken der Spitze der spontanen Emission fällt.

## Claims

1. Amplitude optical modulator, comprising a semiconductor structure (10) of the distributed feedback laser type, two electrodes (18, 18') located on said structure, means (20, 20') for producing two currents (I, I') and for applying them to the two electrodes (18, 18') in order to supply the structure below the laser oscillation threshold, the structure then having a spontaneous emission peak (S₀, S₁, S₂) with a rising edge and a trailing edge and means (32, 34) for the intensity modulation of at least one of the two currents (I'), said modulator being able to amplitude modulate an optical beam (31) passing through it and having a wavelength (λᵢ) dropping on one of the edges of the spontaneous emission peak.
